# EUROPEAN PATENT APPLICATION

(11) **EP 4 295 978 A1**
(43) Date of publication of application: **27.12.2023**
(21) Application number: 21926659.0
(22) Date of filing: 30.07.2021
(51) Int. Cl.: B23B 27/14, B23C 5/16, C23C 14/06

(54) **SURFACE-COATED CUTTING TOOL**

(30) Priority: 19.02.2021 JP 2021024876
(71) Applicant: Mitsubishi Materials Corporation, Tokyo 100-8117 (JP)
(72) Inventor: ASANUMA Hidetoshi, Tokyo 100-8117 (JP); EBATA Tomoki, Tokyo 100-8117 (JP)
(74) Representative: Gille Hrabal Partnerschaftsgesellschaft mbB Patentanwälte
(86) International application number: PCT/JP2021/028272
(87) International publication number: WO 2022/176230

(57) **Abstract**

The coating film includes a laminated structure including at least one first layer and at least one second layer alternately disposed. The or each first layer has an average thickness of 0.5 to 100.0 nm and has an average composition: (AlₓTi_{1-x-y-z}M_{y})B_{z}N, where M is at least one element selected from the group consisting of Groups 4, 5, and 6 elements, and lanthanide elements in the periodic table, 0.100 ≤ x ≤ 0.640, 0.001 ≤ y ≤0.100, and 0.060 ≤ z ≤ 0.400. The or each second layer has an average thickness of 0.5 to 100.0 nm and has an average composition: (AlpCr_{1-p-q-r}M'_{q})BᵣN, where M' is at least one element selected from the group consisting of Groups 4, 5, and 6 elements, and lanthanide elements in the periodic table, 0.650 ≤ p ≤ 0.900, 0.000 ≤ q ≤ 0.100, and 0.000 ≤ r ≤ 0.050.

## Description

### Technical Field

The present invention relates to a surface-coated cutting tool (hereinafter may be referred to as a coated tool). This application claims the priority benefit of Japanese Patent Application No. 2021-24876 filed on February 19, 2021. The entire contents described in the Japanese patent application are thereby incorporated by reference herein.

### Background Art

Generally known coated tools are categorized into inserts that are each detachably attached to the tip of a cutting tool for turning and planing of work materials, such as various steels and cast irons; drills and miniature drills used for drilling and cutting of work materials; solid end mills used for facing, grooving, and shouldering of work materials; and insert end mills that includes inserts detachably mounted for cutting, like solid end mills.

Known coated tools includes, for example, tool substrates provided with surface coating films composed of WC-based cemented carbide. Various proposals focusing on the composition and structure of the tool substrate and coating film have been made for the purpose of improving cutting performance.

For example, PTL 1 discloses a coated tool that includes a coating film of 0.8 to 5.0 µm deposited on a surface of a tool substrate, where the coating film has an alternately laminated structure of thin layers A composed of a granular crystal structure of a composite nitride of Ti, Al and B,. and thin layers B composed of a columnar crystal structure, the thin layers A and B each have a thickness of 0.05 to 2.0 µm, the granular crystal structure has an average crystal grain size of 30 nm or less, and the columnar crystal structure has an average crystal grain size of 50 to 500 nm. This coated tool has excellent wear resistance even in high-speed, high-feed cutting of hardened steel.

### Citation List

### Patent Literature

[PTL 1] Japanese Unexamined Patent Publication No. 2011-224717

### Summary of Invention

An object of the present invention, which has been completed in view of the above circumstances and proposals, is to provide a coated tool that exhibits excellent wear resistance and chipping resistance, for example, even in high-speed cutting, which is at least 30% higher than normal conditions, of stainless steel, such as austenitic stainless steel.

### Solution to Problem

A surface-coated cutting tool according to an embodiment of the present invention includes:
a tool substrate and a coating film, wherein
the coating film has an average thickness of 0.2 to 10.0 µm, and includes a laminated structure including at least one first layer and at least one second layer alternately disposed and the or each first layer has an average thickness of 0.5 to 100.0 nm and has an average composition represented by the formula: (AlₓTi_{1-x-y-z}M_{y})B_{z}N, where M is at least one element selected from the group consisting of Groups 4, 5, and 6 elements, and lanthanide elements in the periodic table, x is in a range of 0.100 to 0.640, y is in a range of 0.001 to 0.100, and z is in a range of 0.060 to 0.400;
the or each second layer has an average thickness of 0.5 to 100.0 nm and has an average composition represented by the formula: (AlₚCr_{1-p-q-r}M'_{q})BᵣN, where M' is at least one element selected from the group consisting of Groups 4, 5, and 6 elements, and lanthanide elements in the periodic table, p is in a range of 0.650 to 0.900, q is in a range of 0.000 to 0.100, and r is in a range of 0.000 to 0.050.

The surface-coated cutting tool according to the embodiment may satisfy the following requirements. (1) The total number of each first layer and each second layer is in a range of 30 to 800.

### Advantageous Effects of Invention

As described above, the surface-coated cutting tool exhibits excellent wear resistance and chipping resistance even in high-speed cutting of stainless steel, such as austenitic stainless steel.

### Brief Description of Drawings

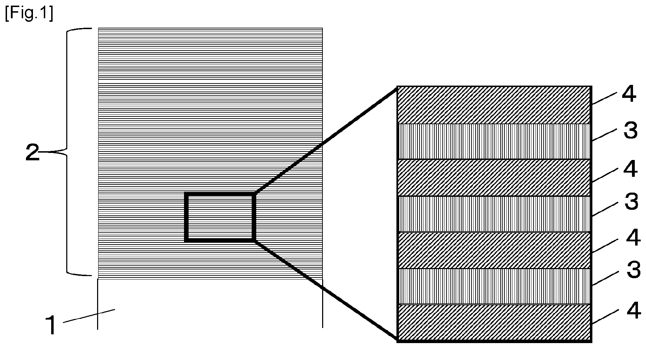

FIG. 1 is a schematic longitudinal sectional view of a coating film of a surface-coated cutting tool according to an embodiment of the present invention.

### Description of Embodiments

The present inventors have extensively studied a coated tool that exhibits excellent wear resistance even in use for high-speed cutting of stainless steel, such as austenitic stainless steel. Since a coating film containing B is brittle regardless of excellent wear resistance, the inventors concluded that simply forming the coating film containing B cannot achieve both wear resistance and chipping resistance and have further continued extensive study. As a result, the inventors have found that a coating film having a laminated structure with variable compositions on Al and B can block the propagation of cracks generated during cutting, and can achieve compatibility between wear resistance and chipping resistance.

The coated tool according to embodiments of the present invention will now be described in detail. Throughout the specification and claims, a numerical range "A to B" includes the upper limit (B) and the lower limit (A). In the case that the unit is described only for the upper limit (B), the lower limit (A) also have the same unit.

The laminated structure of the coating film of the coated tool according to the embodiment of the present invention is as shown in FIG. 1.

### 1. Coating film

The coating film will now be described in detail.

### (1) Average thickness

The coating film in the coated tool according to this embodiment has an average thickness in a range of 0.2 to 10.0 µm for the following reasons: An average thickness of less than 0.2 µm fails to achieve excellent abrasion resistance of the tool over long-term use. An average thickness exceeding 10.0 µm often causes coarse crystal grains to occur in the coating film, precluding an improvement in the chipping resistance. More preferably, the average thickness ranges from 0.8 to 8.0 µm.

Throughout the specification, the average thickness of each layer is determined through cross-sectional observation (observation of a vertical cross-section perpendicular to the surface of the tool substrate) with a scanning electron microscope (SEM) and an energy dispersive X-ray spectroscope (EDS) attached to a transmission electron microscope (TEM).

### (2) Structure of coating film

As shown in FIG. 1, the coating film in the coated tool according to this embodiment has an alternately laminated structure including at least one first layer (3) and at least one second layer (4) on the surface of the tool substrate (1). The or each first layer (3) is an (AITiM)BN layer and the or each second layer (4) is an (AICrM')BN layer. The first layer (3) and the second layer (4) contain crystal grains of NaCl-type face-centered cubic structure.

### (2-1) First layer {(AlTiM)BN layer}

In a preferred embodiment, each first layer has an average thickness in a range of 0.5 to 100.0 nm and an average composition represented by the formula: (AlₓTi_{1-x-y-z}M_{y})B_{z}N where M is at least one element selected from the group consisting of Groups 4, 5, and 6 elements, and lanthanide elements in the periodic table, x is in a range of 0.100 to 0.640, y is in a range of 0.001 to 0.100, and z is in a range of 0.060-0.400.

At an average thickness of less than 0.5 nm of the first layer in the alternately laminated structure including at least one first layer and at least one second layer (each especially 30 or more layers), the laminated structure cannot sufficiently block propagation of cracking resistance. At an average thickness exceeding 100.0 nm, the nano-laminated structure cannot exhibit a sufficient improvement in the abrasion resistance.

The reason why the above average composition is preferred is as follows.

At x of less than 0.100, Al cannot sufficiently improve the heat resistance, whereas at x exceeding 0.640, the hardness decreases and sufficient wear resistance cannot be exhibited.

At y of less than 0.001, sufficient improvements in heat resistance and mechanical properties cannot be achieved, whereas at y exceeding 0.100, toughness is lowered and chipping and fracture are likely to occur.

At z of less than 0.060, a sufficient improvement in hardness cannot be achieved, whereas at z exceeding 0.040, toughness is lowered and chipping and fracture are likely to occur.

### (2-2) Second layer {(AICrM')BN layer}

In a preferred embodiment, each second layer has an average thickness in a range of 0.5 to 100.0 nm and an average composition represented by the formula: (AlₚCr_{1-p-q-r}M'_{q})BᵣN where M' is at least one element selected from the group consisting of groups 4, 5, and 6 elements, and lanthanide elements in the periodic table, p is in a range of 0.650 to 0.900, q is in a range of 0.000 to 0.100, and r is in a range of 0.000 to 0.050.

The element M in each first layer and the element M' in each second layer may be quite different, partly the same, or quite the same.

In the case that at least one first layer and at least one second layer (in particular, 30 or more layers for each) are alternately laminated, an average thickness of the second layer of less than 0.5 nm fails to achieve a sufficient improvement in crack propagation resistance, which is an advantageous effect of the alternately laminated structure. An average thickness exceeding 100.0 nm fails to achieve a sufficient improvement in wear resistance, which is an advantageous effect of the nano-layer structure.

The reason why the above average composition is preferred is as follows.

At p of less than 0.650, the heat resistance cannot be sufficiently improved due to a low Al content. At p exceeding 0.900, hardness decreases to such an extent that sufficient wear resistance cannot be exhibited.

Since M' is not an essential element, the lower limit of q is substantially 0.000. At q exceeding 0.100, toughness is disadvantageously lowered and chipping and fracture are likely to occur.

Since B is not an essential element, the lower limit of r is substantially 0.000. At r exceeding 0.050, toughness is disadvantageously lowered and chipping and fracture are likely to occur.

### (2-3) Alternately laminated structure including at least one first layer and at least one second layer

The coating film preferably has an alternately laminated structure including at least one first layer and at least one second layer. The second layer with a low B content offsets the high brittleness of the first layer with a high B content having high wear resistance. As a result, the overall coating film can exhibit superior wear resistance and chipping resistance against high-speed cutting of stainless steel, such as austenitic stainless steels. It should be noted that the alternately laminated structure may consist of a single first layer and a single second layer. The bottommost layer in contact with the tool substrate (or a lower layer if present) may be either a first layer or a second layer. The topmost layer closest to the surface may be either a first layer or a second layer.

No particular restriction is provided on the total deposited number of the first layer(s) and the second layer(s), provided that the structure includes at least one first layer and at least one second layer alternately laminated, each first layer and each second layer satisfy the average thickness in the above-mentioned range, and the coating film has the above-mentioned average thickness. For example, even a single first layer and a single second layer can achieve the object of the present invention. However, in order to ensure the object of the present invention more reliably, the alternately laminated structure consists of preferably 30 to 800 layers, more preferably 50 to 750 layers.

### (3) Other layers

Although the object of the present invention can be achieved by a laminated structure including at least one first layer and at least one second layer in the coating film, the surface of the coating film may be covered by a TiN layer and/or the tool substrate may be covered by a lower layer. Since the TiN layer has a golden color tone, the TiN layer can be used as an identification layer that can distinguish, for example, the states of use of the cutting tool (unused or used), by a change in the color tone on the tool surface.

The TiN layer as the identification layer may have an average thickness in a range of, for example, 0.1 to 1 µm.

The lower layer is provided between the tool substrate and the alternately deposited layers.

The average thickness of the coating film is determined through measurement of several points (for example, 10 points) selected at random in a cross section parallel to the normal direction of the surface of the tool substrate for each layer of the entire coating film and calculation of the average thickness. The average composition of the first layer and the second layer of the coating film is determined through calculation of the average of the compositions at several points (for example, 10 points) selected at random in the central zone of each layer across the thickness.

### 2. Tool Substrate

### (1) Material

The tool substrate used in the embodiment may be composed of any known material for tool substrates, provided that the material does not hinder the achievement of the object of the present invention. For example, preferred are cemented carbides (WC-based cemented carbides, containing Co in addition to WC, and further containing carbonitrides such as Ti, Ta, and/or Nb), cermets (TiC, TiN, and/or TiCN, as main components), ceramics (primarily composed of silicon nitride or aluminum oxide, for example), cBN sintered compacts, and diamond sintered compacts.

### (2) Shape

The tool substrate may have any shape employed in cutting tools, for example, the shape of an insert and the shape of a drill.

### 3. Production

The coating film of the coated tool of the present invention can be produced with any deposition system (arc ion plating (AIP) system) having an arc vapor deposition source, which is a type of PVD. The first layer can be deposited with an AlTiMB target while the second layer can be deposited with an AlCr or AICrM target, by arc discharge.

### Examples

The present invention will now be described in detail by way of examples.

Coated tools of the present invention are insert cutting tools each including a substrate composed of WC-based cemented carbide. The tool substrates may be made of materials described above. Other coated tools, such as drills and end mills are also included in the category of the present invention.

Co powder, VC powder, TiC powder, TaC powder, NbC powder, Cr₃C₂ powder, and WC powder were blended in the formulation shown in Table 1 to prepare Compositions for Tool Substrates 1 to 3. Wax was further added to each of the Compositions for Tool Substrates 1 to 3. Each mixture was wet-mixed in a ball mill for 72 hours, was dried under reduced pressure, and then was compacted under a pressure of 100 MPa to produce a green compact. The green compact was sintered and then the sintered compact was shaped into predetermined dimensions. Tool substrates 1 to 3 made of WC-based cemented carbide and having an insert shape with model number SEEN1203AFTN1 (manufactured by Mitsubishi Materials Corporation) were thereby produced.

Tool Substrates 1 to 3 were then ultrasonically cleaned in acetone and then dried. Each tool substrate was mounted along the outer periphery at a position radially away by a predetermined distance from the central axis of a turn table in an AIP system. An AITiM target and an AlCr or AICrM target were disposed as cathodes (evaporation source).

While the deposition system was evacuated and maintained at a vacuum of 10⁻² Pa or less, the inside of the system was heated to 400°C with a heater. A DC bias voltage of -1000 V was then applied to the tool substrate rotating on the turn table in an Ar gas atmosphere of 1.0 Pa for 60 minutes for bombardment with argon ions on the tool substrate surface. It is appreciated that the bombardment with argon ions may be replaced with bombardment with metal ions using a metal target.

Nitrogen reaction gas having a pressure within the range of 0.1 to 9.0 Pa shown in Table 2 was introduced into the deposition system for a predetermined time, and the temperature inside the furnace was maintained as shown in Table 2. A predetermined DC bias voltage within the range of -10 to -500 V shown in Table 2 was applied to the tool substrate rotating (planetary rotation) on the turn table to generate a current within the range of 80 to 240 A shown in Table 2 for arc discharge. Coated tools 1 to 9 of the present invention shown in Table 3 were thereby produced.

For comparison, a coating film was vapor-deposited on Tool Substrates 1 to 3 in the same deposition system under the conditions shown in Table 2, to form Comparative Coated Tools 1 to 9 shown in Table 4.

The average thickness of the coating film, the average thickness and the average composition of each first layer and each second layer were determined by observation of the vertical section of the coating film perpendicular to the surface of each of Tool Substrates of Examples 1 to 9 and Comparative Examples 1 to 9 by scanning electron microscopy (SEM), transmission electron microscopy (TEM), and energy dispersive X-ray spectroscopy (EDS). The average thickness of the coating film was determined by averaging the thicknesses at 10 points selected at random on a cross-section of the coating film perpendicular to the surface of the tool substrate over the entire coating film (magnification for observation was appropriately selected according to the thickness of the layer). The average composition of the first layer and the second layer of the coating film was determined through calculation of the average value of 10 points in the central region across the thickness of each layer.

X-ray diffractometry (XRD) confirmed that each layer had crystals of a NaCl-type face-centered cubic crystal structure.

**[Table 1]**

| Tool Substrat e | Composition (Mass%) | | | | | | |
|---|---|---|---|---|---|---|---|
| | Co | TiC | VC | TaC | NbC | Cr₃C₂ | WC |
| 1 | 8.0 | 0. 0 | 1.0 | 0. 0 | 1.0 | 0. 0 | Balance |
| 2 | 11. 0 | 0. 0 | 1.5 | 0. 0 | 0. 0 | 0. 5 | Balance |
| 3 | 9. 0 | 0. 5 | 0. 0 | 1.0 | 0. 5 | 0. 0 | Balance |

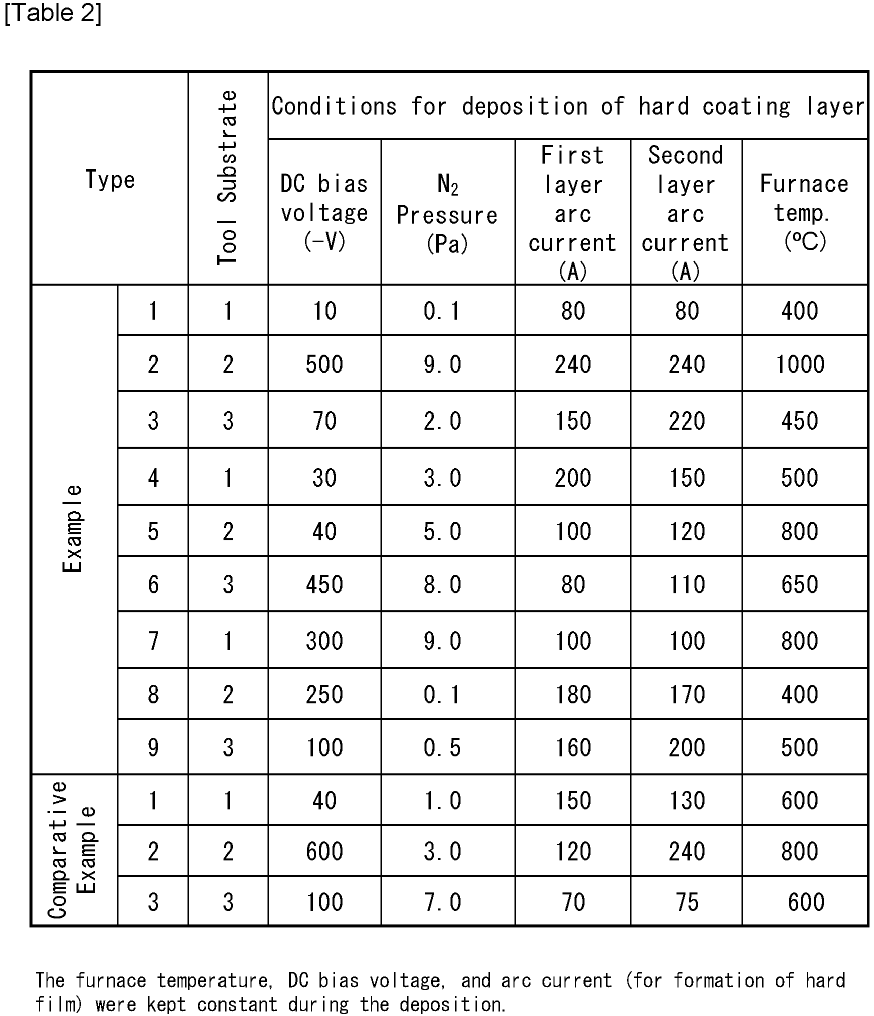

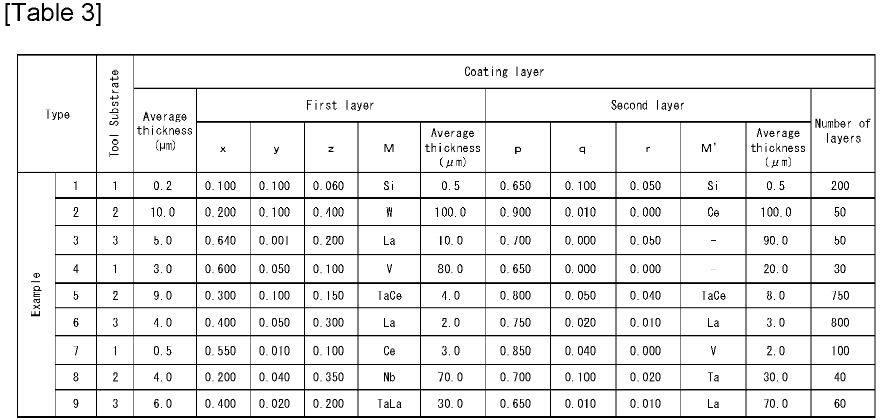

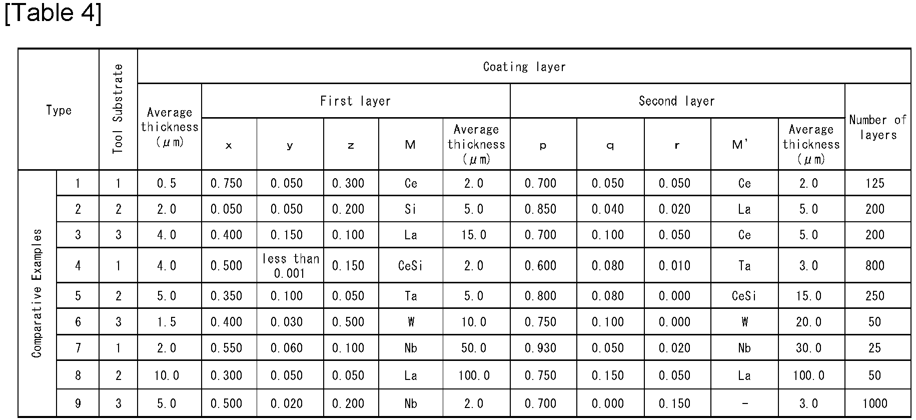

The coated tools of Examples 1 to 9 and Comparative Examples 1 to 9 were then subjected to a single-blade face milling test using a cutter of model number SE445R0506E (manufactured by Mitsubishi Materials Corporation). High-speed cutting tests were performed with austenitic stainless steels under the following cutting conditions;

### Cutting condition A:

Work material: stainless steel SUS304, a block of width 60 mm by length 200 mm
Cutting speed: 200 m/min
Cutting depth: 1.3 mm
Feed: 0.27 mm/tooth

After cutting was continued up to a cutting length of 1.8 m, the flank wear width was measured, and the wear state of the cutting edge was observed.

Table 5 shows the results of the cutting tests.

### Cutting condition B:

Work material: stainless steel SUS316, a block of width 60 mm by length 200 mm
Cutting speed: 180 m/min
Cutting depth : 1.5 mm
Feed: 0.25 mm/tooth

After cutting was continued up to a cutting length of 1.8 m, the flank wear width was measured, and the wear state of the cutting edge was observed.

Table 6 shows the results of the cutting tests.

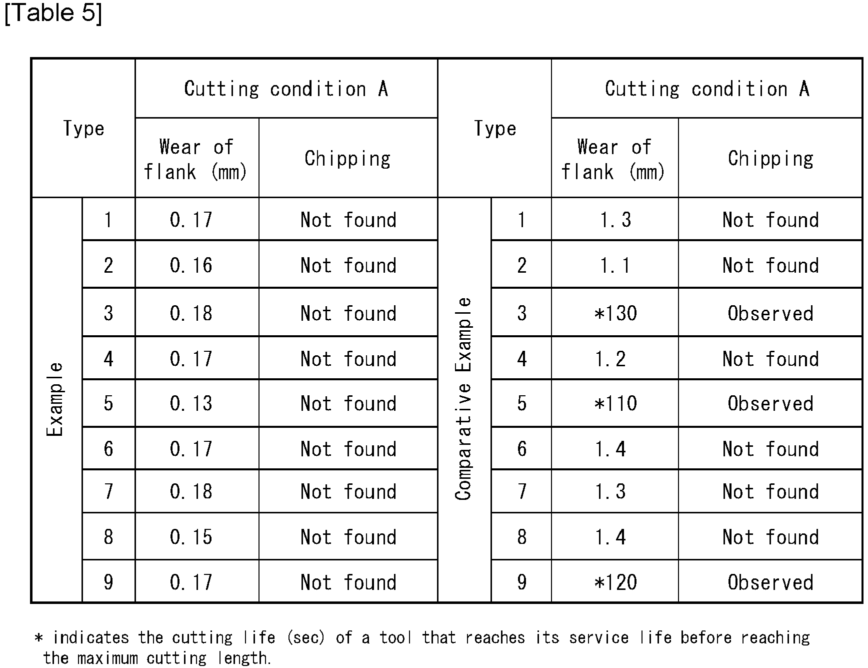

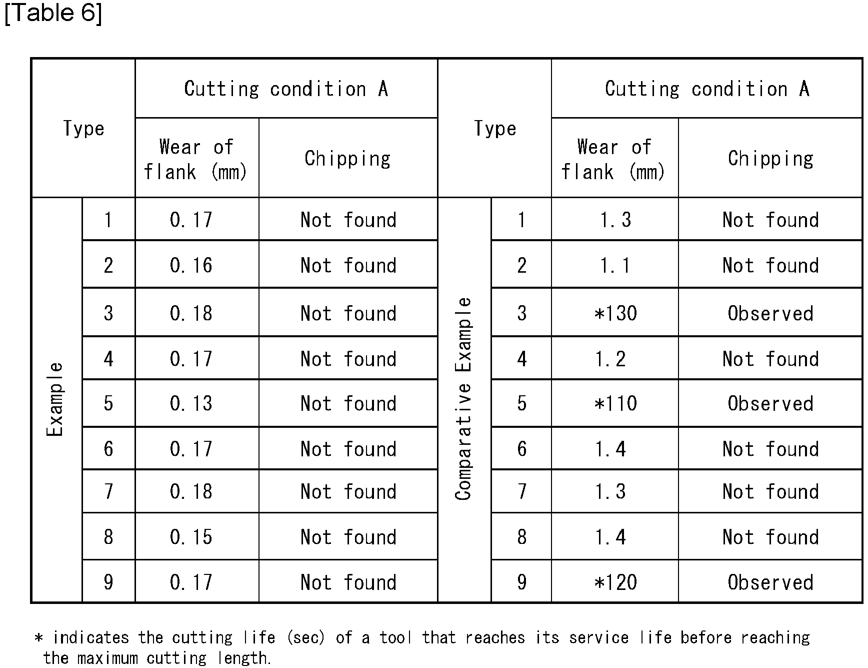

Tables 5 and 6 evidentially demonstrate that samples in Examples 1 to 9 exhibit superior wear resistance and chipping resistance without abnormal damage such as chipping or flaking under any of the cutting conditions A and B.

In contrast, samples in Comparative Examples 1 to 9 reach their service lives for short times due to chipping or noticeable flank wear under both cutting conditions A and B.

### Reference Signs List

1 Tool substrate
2 Coating film
3 (AITiM)BN layer
4 (AICrM')BN layer

## Claims

1. A surface-coated cutting tool comprising:
a tool substrate and a coating film, wherein
the coating film has an average thickness of 0.2 to 10.0 µm, and includes a laminated structure including at least one first layer and at least one second layer alternately disposed, and
the or each first layer has an average thickness of 0.5 to 100.0 nm and has an average composition represented by the formula: (AlₓTi_{1-x-y-z}M_{y})B_{z}N, where M is at least one element selected from the group consisting of Groups 4, 5, and 6 elements, and lanthanide elements in the periodic table, x is in a range of 0.100 to 0.640, y is in a range of 0.001 to 0.100, and z is in a range of 0.060 to 0.400;
the or each second layer has an average thickness of 0.5 to 100.0 nm and has an average composition represented by the formula: (AlₚCr_{1-p-q-r}M'_{q})BᵣN, where M' is at least one element selected from the group consisting of Groups 4, 5, and 6 elements, and lanthanide elements in the periodic table, p is in a range of 0.650 to 0.900, q is in a range of 0.000 to 0.100, and r is in a range of 0.000 to 0.050.

2. The surface-coated cutting tool set forth in claim 1, the total number of each first layer and each second layer is in a range of 30 to 800.
